# EUROPEAN PATENT APPLICATION

(11) **EP 4 089 915 A1**
(43) Date of publication of application: **16.11.2022**
(21) Application number: 22172826.4
(22) Date of filing: 11.05.2022
(51) Int. Cl.: H03F 3/00, G11C 27/02, H03F 3/45, H03G 1/00, H03M 1/12

(54) **BUFFER WITH GAIN SELECTION**

(30) Priority: 11.05.2021 GB 202106695
(71) Applicant: Nordic Semiconductor ASA, 7052 Trondheim (NO)
(72) Inventor: WU, Hsin-Ta, 7052 Trondheim (NO)
(74) Representative: Dehns

(57) **Abstract**

An electronic device (200) has an amplifier (206) having an amplifier input terminal (208) and an amplifier output terminal (212), the amplifier output terminal (212) being connected to the device output terminal (204). An input capacitor (216) is connected between the device input terminal (202) and the amplifier input terminal (208). A feedback capacitor (220) is connected between the amplifier output terminal (212) and the amplifier input terminal (208). A switchable capacitor (252) has a first terminal connected to the amplifier input terminal (208) and a second terminal connected to a respective first terminal of each of a first switch (254) and a second switch (256). The first switch (254) has its second terminal connected to the device input terminal (202). The second switch (256) has its second terminal connected to the amplifier output terminal (212). In this arrangement, the switchable capacitor (252) can be switched between forming part of the input path of the amplifier (206) or the feedback path of the amplifier (206).

## Description

### Technical Field

The present invention relates to a buffer, particularly though not exclusively in relation to a buffer for use in sample-and-hold circuits such as in an analogue-to-digital converter front-end, where the buffer is arranged for the selection of different gain ratios.

### Background to the Invention

Many modern electronic devices include one or more sample-and-hold circuits, i.e. circuits that capture a sample of a continuously varying voltage (i.e. analogue signal) and store it as a constant value for some predetermined period of time until the next capture is done. Sample-and-hold circuits are typically used in analogue-to-digital converters (ADCs) which convert an analogue signal into a digital signal.

Such sample-and-hold circuits typically include at least one buffer which acts to pass signals from one stage of the circuit to another. Typically these buffers are implemented using an amplifier, which may be a unity gain amplifier (i.e. an amplifier that produces an output of substantially the same amplitude or level as its input) or the amplifier may have non-unity gain.

As will be appreciated by those skilled in the art, non-unity gain may generally be achieved by providing the amplifier with closed loop feedback, where a capacitance in the feedback path of the amplifier is different to a capacitance in the input path of the amplifier, where the ratio of feedback capacitance to input capacitance sets the gain of the amplifier.

In order to provide such a buffer with configurable gain, capacitor arrays (i.e. a matrix of capacitors) may be provided. In other words, a bank of capacitors may be used for the input and/or feedback path capacitances, where an appropriate selection of capacitors within the array(s) may be enabled to acquire a particular ratio. However, the Applicant has appreciated that such an approach has certain disadvantages.

The inclusion of a large number of capacitors may have significant detrimental effects due to the increased parasitic capacitance within the device. Having a large number of floating capacitors can interfere with operation of the rest of the circuit.

Including a large number of capacitors also increases the physical dimensions of the device, because each capacitor will require physical space on the device. This may be a particular problem where physical space is a design constraint.

Additionally, such an approach can have a negative impact on the power supply rejection ratio (PSRR), i.e. the degree to which the device can ignore fluctuations in the power supply. This is particularly problematic in some sample-and-hold applications, such as in an ADC, in particular when high resolution is required (e.g. a 12- or 14-bit ADC may be more sensitive to power supply fluctuations than an 8-bit ADC). Those skilled in the art will appreciate that with a poorer PSRR, fluctuations on the power supply have a worse effect on operational accuracy.

### Summary of the Invention

When viewed from a first aspect, embodiments of the present invention provide an electronic device having a device input terminal and a device output terminal, the device comprising:
an amplifier having an amplifier input terminal and an amplifier output terminal, said amplifier output terminal being connected to the device output terminal;
an input capacitor having a first terminal thereof connected to the device input terminal, and a second terminal thereof connected to the amplifier input terminal;
a feedback capacitor having a first terminal thereof connected to the amplifier output terminal, and a second terminal thereof connected to the amplifier input terminal; and
a switchable capacitor having a first terminal thereof connected to the amplifier input terminal, and a second terminal thereof connected to a respective first terminal of each of a first switch, a second switch, and a third switch;
wherein the first switch has a second terminal thereof connected to the device input terminal;
wherein the second switch has a second terminal thereof connected to the amplifier output terminal; and
wherein the third switch has a second terminal thereof connected to ground or virtual ground, such that the switchable capacitor may be disconnected altogether when it is not required.

Thus it will be appreciated that the electronic device of the present invention is arranged such that the switchable capacitor may be connected either in parallel with the input capacitor by closing the first switch, in parallel with the feedback capacitor by closing the second switch, or connected to ground (or virtual ground) by closing the third switch. The capacitor ratio may therefore be set by closing either the first switch or the second switch, and the switchable capacitor may be advantageously be disconnected altogether when it is not needed.

It can be seen, therefore, that the same switchable capacitor is advantageously arranged to form part of either the input path or the feedback path of the amplifier, which allows the capacitance ratio to be changed accordingly. This may provide for a significant reduction in the total number of capacitors required to provide for gain control, because rather than having an array of matrix of capacitors in the input and/or feedback paths, the circuit can be reconfigured, making shared use of the capacitor resources as appropriate.

Reducing the number of capacitors in this way provides a number of significant benefits. Firstly, having fewer capacitors may reduce the overall physical size of the device. A reduction in the number of capacitors may also advantageously reduce the parasitic capacitance, thereby improving the performance of the device as a whole. The arrangement of the present invention is also more resilient against fluctuations in the power supply, i.e. it exhibits improvements in terms of its PSRR.

Allowing the switchable capacitor to be disconnected altogether when not needed may provide significant further improvements in the PSRR of the device. By avoiding the switchable capacitor being left floating when it is not in use, significant PSRR improvements can be observed.

By providing more switchable capacitors, a greater number of ratios may be obtained. In some embodiments, the device further comprises:
a second switchable capacitor having a first terminal thereof connected to the amplifier input terminal, and a second terminal thereof connected to a respective first terminal of each of a fourth switch and a fifth switch;
wherein the fourth switch has a second terminal thereof connected to the device input terminal; and
wherein the fifth switch has a second terminal thereof connected to the amplifier output terminal.

A further capacitor may be connected in parallel with the second switchable capacitor. Thus, in a set of such embodiments, the device further comprises:
a third switchable capacitor having a first terminal thereof connected to the amplifier input terminal, and a second terminal thereof connected to the respective first terminals of the fourth and fifth switches.

The device may be arranged such that the second terminal of the second switchable capacitor is connected to a first terminal of a sixth switch, wherein a second terminal of said sixth switch is connected to a second predetermined reference voltage, which in some such embodiments is ground (or a virtual ground) - i.e. this may be the same predetermined reference voltage referred to hereinabove with respect to the third switch. In accordance with such embodiments, the second switchable capacitor may advantageously be disconnected altogether when it is not needed. In embodiments where a third switchable capacitor is provided in parallel with the second switchable capacitor, this sixth switch also serves to disconnect the third switchable capacitor when it is not needed.

The capacitance of each of the capacitors may be chosen as desired, however in some embodiments each of the capacitors has a respective capacitance equal to a respective integer multiple of a unit capacitance. In other words, in such embodiments, all of the capacitors has a common factor to their respective capacitance value. This is particularly advantageous as it allows for ratios of x:y to be selected where x and y are both integers.

For example, in a particular set of embodiments in which the second and third switchable capacitors are present, and the third and sixth switches are also present, the ratio may be selected from 2:3, 1:1, 2:1, 4:1, and 1:2 if each of the capacitors has the same capacitance (i.e. they each have a unit capacitance).

In some embodiments, the device further comprises:
a first sampling switch having a first terminal thereof connected to the amplifier input terminal and a second terminal thereof connected to a third predetermined reference voltage;
a second sampling switch having a first terminal thereof connected to the amplifier output terminal and a second terminal thereof connected to a fourth predetermined reference voltage; and
a third sampling switch having a first terminal thereof connected to the device input terminal and a second terminal thereof connected to the first terminal of the input capacitor. In a particular set of such embodiments, the first, second, and third sampling switches are controlled or controllable such that when said switches are disabled (i.e. opened), the first sampling switch is disabled before the second and third sampling switches are disabled. In other words, the second and third sampling switches are disconnected after some delay following disconnection of the first sampling switch.

Opening the second and third sampling switches may introduce unwanted charge injection. In order to overcome this, a bottom plate sampling technique may be applied, i.e. where the input being sampled is connected to the 'bottom' plate for the capacitor, and where the voltage at the 'top' plate of the capacitor generally returns to zero at the end of each cycle.

The third and/or fourth predetermined reference voltage(s) may, in some such embodiments, be ground (or virtual ground). Closing the first sampling switch causes the voltage at the device input terminal to be 'captured' by the buffer, i.e. for sample-and-hold functionality. The first terminal of the second sampling switch may be connected to the second terminal of the feedback capacitor.

In a set of potentially overlapping embodiments, the device further comprises:
a first amplifier enable switch having a first terminal thereof connected to the amplifier output terminal and a second terminal thereof connected to the second terminal of the feedback capacitor; and
a second amplifier enable switch having a first terminal thereof connected to the first terminal of the input capacitor. In other words, the first amplifier enable switch may sit between the output of the amplifier and the feedback capacitor. Closing these amplifier enable switches enables operation of the amplifier by closing its feedback loop. A second terminal of the second amplifier enable switch may, in some embodiments, be connected to a fifth predetermined reference voltage. The fifth predetermined reference voltage may, in some such embodiments, be ground (or virtual ground). Such an arrangement may be beneficial in a set of embodiments in which the buffer is used in a single-ended configuration.

As mentioned above, the buffer may be single-sided, such that its input is a single-sided signal and it produces a single-sided output. However, in some embodiments, the buffer comprises a differential buffer. Thus, in some embodiments, the electronic device has a second device input terminal and a second device output terminal, wherein:
the amplifier has a second amplifier input terminal and a second amplifier output terminal, said second amplifier output terminal being connected to the second device output terminal;
wherein the electronic device further comprises:
   a second input capacitor having a first terminal thereof connected to the second device input terminal, and a second terminal thereof connected to the second amplifier input terminal;
   a second feedback capacitor having a first terminal thereof connected to the second amplifier output terminal, and a second terminal thereof connected to the second amplifier input terminal; and
   a fourth switchable capacitor having a first terminal thereof connected to the second amplifier input terminal, and a second terminal thereof connected to a respective first terminal of each of a seventh switch and an eighth switch;
   wherein the seventh switch has a second terminal thereof connected to the second device input terminal; and
   wherein the eighth switch has a second terminal thereof connected to the second amplifier output terminal.

In some such embodiments, the amplifier may be arranged such that:
the first amplifier input is an inverting input;
the second amplifier input is a non-inverting input;
the first amplifier output is a non-inverting output; and
the second amplifier output is an inverting output.

Each of the capacitors may have a fixed capacitance, or may have a variable capacitance. One or more of the capacitors may comprise a capacitor array. It will be appreciated that while the present invention aims to avoid the need for capacitor arrays for controlling the gain of the buffer, the present invention allows a given capacitor array to be 're-used' within either the input or feedback path, thus still providing a net reduction in the number of capacitors, thereby still providing the benefits of the invention. However, it is preferred that the capacitors each have a fixed capacitance, and that the fixed capacitance of each capacitor is equal to an integer multiple of a unit capacitance, as outlined previously.

While metal-oxide-semiconductor (MOS) capacitors could be used, in preferred embodiments one or more of the capacitors (and preferably all of the capacitors) comprises a metal capacitor. Metal capacitors are, in general, preferred in order to improve the quality factor (or 'Q-factor') of the capacitor network.

Control of the various switches may be provided by means of a control logic, which in some embodiments may form part of the electronic device or which may be external. The same control logic may control all of the switches, or control of the switches may be divided across multiple controllers, each controlling one or more of the switches, as appropriate. Such control logic may supply control signals to a respective control terminal of each switch. The switches may, in some embodiments, each comprise a field-effect-transistor (FET) where the gate terminal of that FET can be used to selectively enable or disable the flow of current between the drain and source terminals of that FET.

From a further aspect the invention provides an electronic device having a device input terminal and a device output terminal, the device comprising:
an amplifier having an amplifier input terminal and an amplifier output terminal, said amplifier output terminal being connected to the device output terminal;
an input capacitor having a first terminal thereof connected to the device input terminal, and a second terminal thereof connected to the amplifier input terminal;
a feedback capacitor having a first terminal thereof connected to the amplifier output terminal, and a second terminal thereof connected to the amplifier input terminal; and
a switchable capacitor having a first terminal thereof connected to the amplifier input terminal, and a second terminal thereof connected to a respective first terminal of each of a first switch and a second switch;
wherein the first switch has a second terminal thereof connected to the device input terminal; and
wherein the second switch has a second terminal thereof connected to the amplifier output terminal.

It will be appreciated that the recitals of an element being labelled with a particular nominal such as 'third' or 'seventh' does not necessitate the inclusion of those same elements have lower such nominal labels, and such labelling is used for ease of reference only.

It will be appreciated that any and all of the optional features described hereinabove with respect to certain embodiments of the present invention may be combined in any appropriate combination or permutation, unless context dictates otherwise.

### Brief Description of Drawings

Certain embodiments of the invention will now be described, by way of non-limiting example only, with reference to the accompanying drawings in which:
Fig. 1 is a schematic diagram of an electronic device with a buffer circuit in accordance with an embodiment of the present invention;
Fig. 2 is a schematic diagram of a genericised version of an electronic device in accordance with an embodiment of the present invention;
Fig. 3 is a schematic diagram of a single-ended configuration of a genericised electronic device in accordance with an embodiment of the present invention;
Fig. 4 is a plot illustrating the PSRR improvements provided by embodiments of the present invention; and
Fig. 5 is a schematic diagram of an electronic device with a differential configuration.

### Detailed Description

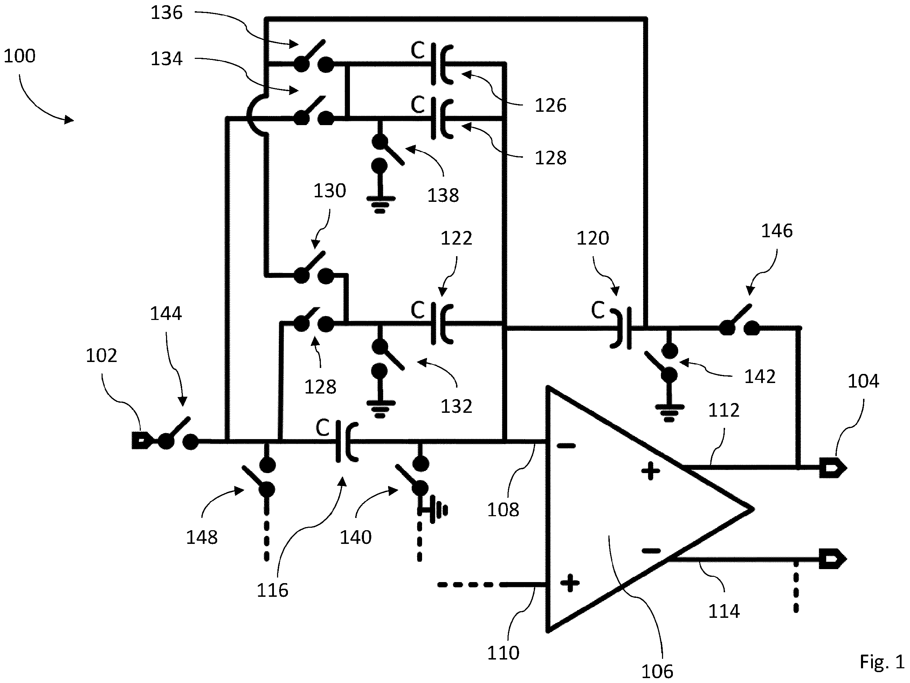

Fig. 1 is a schematic diagram of an electronic device 100 with a buffer circuit in accordance with an embodiment of the present invention. The device 100 is suitable for use in a sample-and-hold circuit, such as in an ADC. The electronic device 100 of Fig. 1 is arranged to receive an input signal at a device input terminal 102, and to produce a buffered version of the signal at an output terminal 104 of the device.

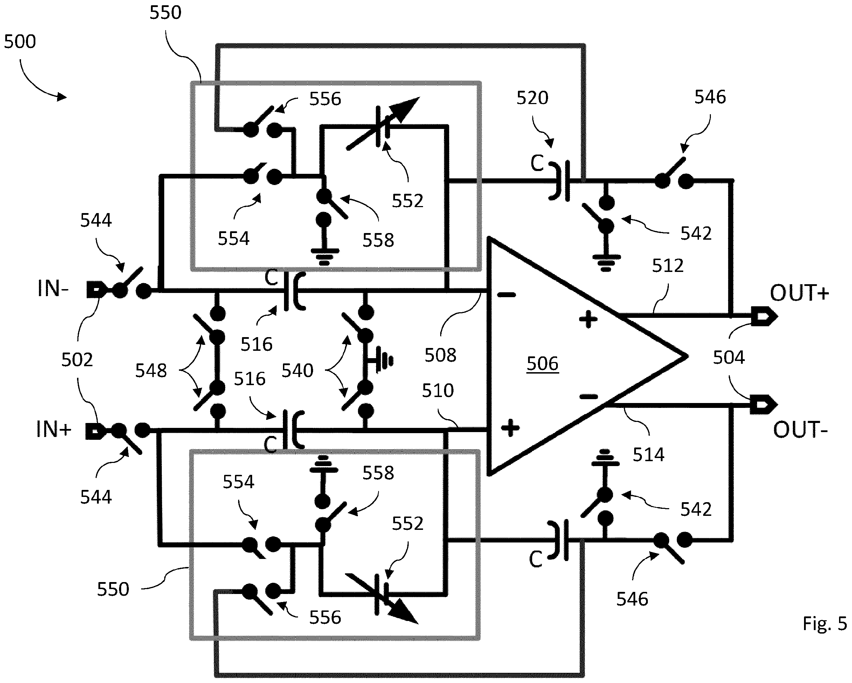

The device 100 includes an amplifier 106, which has an inverting input terminal 108, a non-inverting input terminal 110, a non-inverting output terminal 112, and an inverting input terminal 114. As such, the amplifier 106 can be used as a fully differential amplifier. Alternatively, the amplifier 106 can be configured in a single-sided mode, as is shown in Fig. 1. A differential arrangement is shown in Fig. 5, which is discussed in detail further below.

An input capacitor 116 is arranged in the input path of the amplifier 106, such that one terminal of the input capacitor 116 is connected to the device input terminal 102 (via a switch, outlined below), and the other terminal of the input capacitor 116 is connected to the inverting input terminal 108 of the amplifier 106.

A feedback capacitor 120 arranged in the feedback path of the amplifier 106, such that one terminal of the feedback capacitor 120 is connected to the non-inverting output terminal 112 of the amplifier 106, and the other terminal of the feedback capacitor 120 is connected to the inverting input terminal 108 of the amplifier 106.

The device 100 also comprises three switchable capacitors 122, 124, 126, which are described in further detail below.

The first switchable capacitor 122 is arranged such that one of its terminals is connected to the inverting input terminal of the amplifier 106, and such that its other terminal is connected to respective first terminals of a first switch 128, a second switch 130, and a third switch 132. The first switch 128 has its other terminal connected to the device input terminal 102 (via a switch 144, as outlined below). The second switch 130 has its other terminal connected to the non-inverting output terminal 112 of the amplifier 106. The third switch 132 has its other terminal connected to ground (or virtual ground).

The second and third switchable capacitors 124, 126 are arranged in parallel, with the first terminals of each connected together and to the inverting input 108 of the amplifier 106 (and thus also to the input capacitor 116, first switchable capacitor 122, and feedback capacitor 120). The other terminals of the second and third switchable capacitors 124, 126 are connected together and to respective first terminals of a fourth switch 134, a fifth switch 136, and a sixth switch 138.

The fourth switch 134 has its other terminal connected to the device input terminal 102. The fifth switch 136 has its other terminal connected to the non-inverting output terminal 112 of the amplifier 106 (and therefore to the second terminal of the second switch 130). The sixth switch 138 has its other terminal connected to ground (or virtual ground).

The device 100 also includes three sampling switches 140, 142, 144. The first sampling switch 140 is connected between the inverting input terminal 108 of the amplifier 106 and ground (or virtual ground). The second sampling switch 142 is connected between the non-inverting output terminal 112 of the amplifier 106 and ground (or virtual ground). The third sampling switch 144 is connected between the device input terminal 102 and the first terminal of the input capacitor 116.

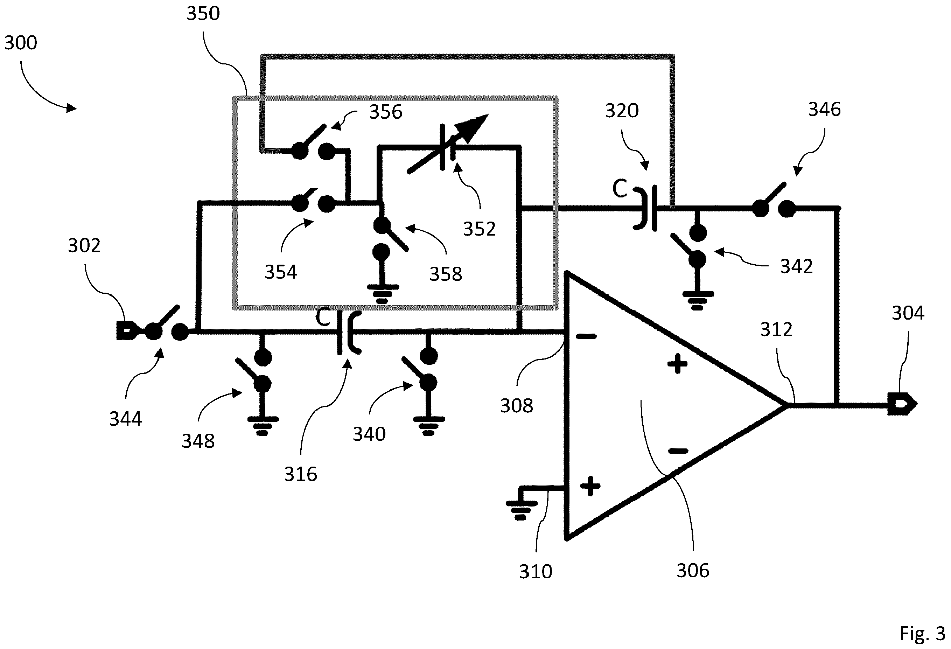

Additionally, the device 100 includes two amplifier enable switches 146, 148. The first amplifier enable switch 146 is connected between the non-inverting output terminal 112 of the amplifier 106 and the second terminal of the feedback capacitor 120. The second amplifier enable switch 148 is connected to the first terminal of the input capacitor 116, and the other terminal of the second amplifier enable switch 148 may be connected to ground (or virtual ground) when the device 100 is used in a single-ended configuration, as is shown in Fig. 3.

Each of the capacitors - the input capacitor 116, feedback capacitor 120, and switchable capacitors 122, 124, 126 - is, in this particular embodiment, a unit capacitance. That is to say, all of these capacitors have the same capacitance 'C'. However, these could be different, where each has a capacitance value equal to an integer multiple of C, e.g. 2C, 3C, 4C, etc. Thus, for example, if the unit capacitance C were equal to 100 µF, a capacitor having a capacitance of 3C would have a capacitance of 300 µF.

Depending on the particular combination of switches closed at any given time, the ratio of the feedback capacitance to the input capacitance can be varied. This is because the switchable capacitors 122, 124, 126 may each be connected to form part of the input capacitance 'C1', the feedback capacitance 'C2', or removed from the circuit such that they contribute to neither the input capacitance C1 nor the feedback capacitance C2.

The control of the switches 128, 130, 132, 134, 136, 138 that adjust the capacitor ratio may be effected by a control logic (not shown for ease of illustration) that supplies control signals to a control terminal of each of the switches. Operation of the switches that control a particular capacitor are exclusive - only one may be enabled at any given time. That is to say, only one of the first through third switches 128, 130, 132 may be enabled (i.e. closed) simultaneously; and only one of the fourth through sixth switches 134, 136, 138 may be enabled (i.e. closed) simultaneously.

For example, when a ratio C1:C2 = 2:3 is desired, the first switch 128 and fifth switch 136 are closed, and the other switches 130, 132, 134, 138 are opened. In this mode, all three of the switchable capacitors 122, 126, 128 are in use, and so the third and sixth switches 132, 138 are opened and no defined potential is needed because there would be no floating capacitors. With this arrangement, the first switchable capacitor 122 forms part of the input capacitance, adding to the input capacitor 116, leading to an input capacitance C1 of 2 * C. Conversely, the second and third switchable capacitors 126, 128 form part of the feedback capacitance, adding to the feedback capacitor 120, leading to a feedback capacitance C2 of 3 * C. This therefore provides the desire C1:C2 = 2:3 ratio.

As another example, if unity gain is desired (i.e. C1:C2 = 1:1), the third and sixth switches 132, 138 are closed, and the other switches 128, 130, 134, 136 are opened. As the switchable capacitors 122, 126, 128 are not in use for this gain mode, closing the third and sixth switches 132, 138 connects the switchable capacitors 122, 126, 128 to a defined potential (ground or virtual ground) to prevent floating capacitors. In this configuration, only the input capacitor 116 contributes to the input capacitance C1, and only the feedback capacitor 120 contributes to the feedback capacitance C2. As these are equal (both having the unit capacitance C), this provides the desired unity gain ratio C1:C2 = 1:1.

In another example, a ratio of C1:C2 = 2:1 may be desired. To achieve this, the first switch 128 and sixth switch 138 may be closed, and the second through fifth switches 130, 132, 134, 136 are opened. This causes the first switchable capacitor 122 to add to the input capacitance alongside the input capacitor 116 (summing to 2 * C), while only the feedback capacitor 120 contributes to the feedback capacitance (which is therefore 1 * C), leading to the desired 2:1 ratio for C1:C2. By closing the sixth switch 138, the second and third switchable capacitors 126, 128 are not left floating, but are instead connected to a defined potential (i.e. ground or virtual ground).

Similar concept can be applied to gain modes of 4:1 (by closing only the first and fourth switches 128, 134) and 1:2 (by closing only the second and sixth switches 130, 138).

The control logic (or some other control logic) may also control operation of the three sampling switches 140, 142, 144 and the two amplifier enable switches 146, 148.

The sampling switches 140, 142, 144 are controlled or controllable such that the first sampling switch is disabled before the second and third sampling switches are disabled, i.e. there is a delay before the second and third sampling switches are disconnected following disconnection of the first sampling switch. The delay between opening the first sampling switch 140 and opening the second and third sampling switches 142, 144 is used in order to avoid introducing unwanted charge injection when the second and third sampling switches 142, 144 are opened. Using the bottom plate sampling technique, known in the art *per se* also helps to address this issue.

The respective control signals applied to the first sampling switch 140 and to the amplifier enable switches 146, 148 are non-overlapping clocks.

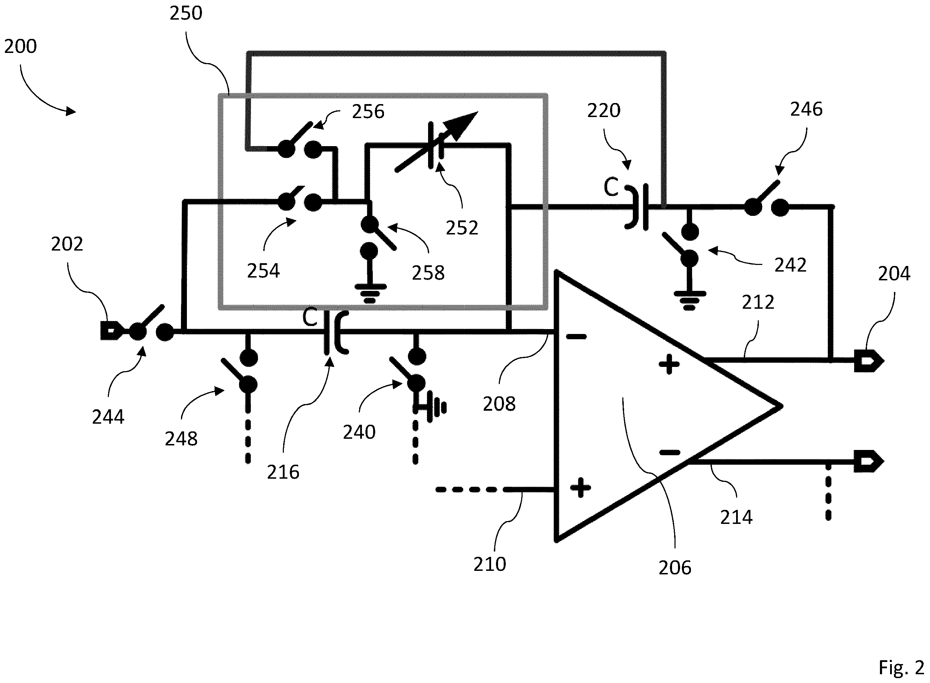

Fig. 2 is a schematic diagram of a genericised version of an electronic device 200 in accordance with an embodiment of the present invention. Elements having a reference numeral starting with a '2' correspond in structure and function to those elements having the same reference numeral starting with a '1' in Fig. 1, unless context dictates otherwise. In other words, an element with reference numeral '2xx' in Fig. 2 corresponds to the element having reference numeral '1xx' in Fig. 1.

As shown in Fig. 2, a generalised switchable capacitor block 250 comprising a switchable capacitor 252 may be configured such that it can contribute to either the input capacitance (by enabling a first switch 254), the feedback capacitance (by enabling a second switch 256), or neither (by enabling a third switch 258). As before, operation of the switches 254, 256, 258 surrounding the capacitor 252 are exclusive - only one may be enabled at any given time.

Any number of these switchable capacitor blocks 250 may be included, connected in parallel with one another, such that each block can be configured independently to form part of the input or feedback capacitance, or to be disconnected.

The switchable capacitor 252 may be a fixed capacitor, or it may be a variable capacitor, implemented e.g. using a capacitor array (i.e. a matrix of capacitors, a subset of which can be enabled for a given capacitance).

Fig. 3 is a schematic diagram of a single-ended configuration genericised electronic device 300 in accordance with an embodiment of the present invention. Elements having a reference numeral starting with a '3' correspond in structure and function to those elements having the same reference numeral starting with a '1' in Fig. 1 and/or with a '2' in Fig. 2, unless context dictates otherwise. In other words, an element with reference numeral '3xx' in Fig. 3 corresponds to the element having reference numeral '1xx' in Fig. 1 and/or '2xx' in Fig. 2.

Unlike in Figs. 1 and 2, in which the amplifier 106, 206 may be arranged in a fully differential configuration (shown in full detail in Fig. 5), in the device 300 of Fig. 3, the amplifier 306 is arranged in a single-ended configuration. In this configuration, the non-inverting input 310 of the amplifier 306 is connected to ground (or virtual ground), and only a single ended output 312 is taken from the amplifier 306. The amplifier enable switch 348 is connected between the input-side of the input capacitor 316 and ground (or virtual ground).

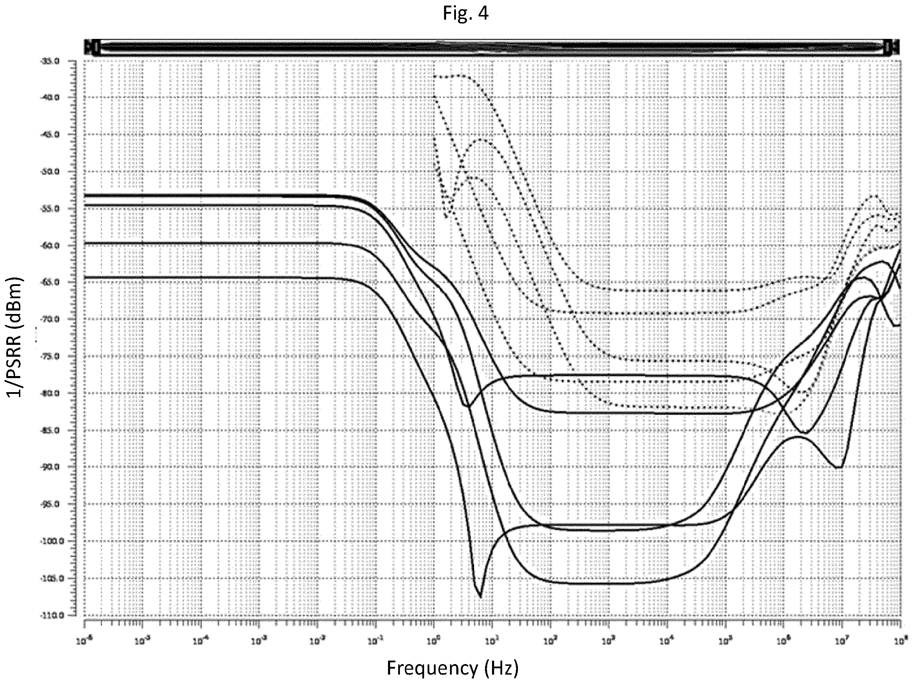

Fig. 4 is a plot illustrating the PSRR improvements provided by embodiments of the present invention. The y-axis shows the inverse of PSRR (i.e. a lower value on the y-axis indicates better PSRR performance), and the x-axis shows frequency. The dotted dashed lines are the PSRR simulation results for a conventional device, known in the art *per se,* with gain modes of 1/1, 2/1, 4/1, and 1/2 using a Monte Carlo statistical mismatch corner. This conventional device used for comparison does not have the ability to terminate the capacitors which are not in use, i.e. they are left floating. By comparison, the solid lines are the PSRR simulation results for the device of Fig. 1 using gain modes of 1/1, 2/1, 4/1, and 1/2 when using the invented Cap Array design with sw3 and sw6 used to terminate the capacitors which are not in use depending on gain mode setting

As can be seen in Fig. 4, devices embodying the present invention achieve significant improvements in PSRR at frequencies < 100Hz, i.e. the plots are shifted downwards. With an improved PSRR, the device also offers better immunity when used within an ADC operated at a high resolution mode, e.g. a 12-bit or 14-bit ADC. At certain gain mode conditions, the device shows a 23 dB PSRR improvement when compared to a conventional device, known in the art *per se.*

Fig. 5 is a schematic diagram of an electronic device 500 with a differential configuration, in accordance with a further embodiment of the present invention. Elements having a reference numeral starting with a '5' correspond in structure and function to those elements having the same reference numeral starting with a '1' in Fig. 1, and/or with a '2' in Fig. 2, and/or with a '3' in Fig. 3, unless context dictates otherwise. In other words, an element with reference numeral '5xx' in Fig. 5 corresponds to the element having reference numeral '1xx' in Fig. 1; '2xx' in Fig. 2; and/or '3xx' in Fig. 3.

For differential operation, the circuit that connected between the inverting input terminal 508 and non-inverting output terminal 512 of the amplifier 506 in Fig. 5 is duplicated, where the duplicate circuit is connected between the non-inverting input terminal 510 and inverting output terminal 514 of the amplifier 506.

In this differential configuration, the device 500 makes use of a further device input and device output, such that the device input 502 takes a voltage across two terminals, where one receives the negative input IN- (which is supplied to the inverting amplifier input 508 as before) and the other receives the positive input IN+ (which is supplied to the non-inverting amplifier input 510). The output is taken across the device output 504 as a positive output OUT+ (taken from the non-inverting amplifier output 512) and a negative output OUT- (taken from the inverting amplifier output 514).

The input-side terminals of the input capacitors 516 on each of the negative and positive sides of the device are connected together via a pair of amplifier enable switches 548. The respective first sampling switches 540 for each of the negative and positive sides of the device are connected together at a ground node.

A generalised switchable capacitor block 550 is provided for each of the positive and negative sides of the amplifier 506. Each such block 550 comprises a switchable capacitor 552 that may be configured such that it can contribute to either the input capacitance (by enabling a first switch 554), the feedback capacitance (by enabling a second switch 556), or neither (by enabling a third switch 558). As before, operation of the switches 554, 556, 558 surrounding the capacitor 252 are exclusive - only one may be enabled at any given time.

Any number of these switchable capacitor blocks 550 may be included as discussed previously, however there will generally be the same number of blocks 550 on the negative side as on the positive side.

Control of the various sampling switches 540, 542, 544 and amplifier enable switches 546, 548 is as discussed previously, where each of the switches on the negative side of the device are generally controlled in synchronisation with the corresponding switches (i.e. those having the same reference number) on the positive side of the device.

Thus it will be appreciated that embodiments of the present invention provide an improved buffer device for use in sample-and-hold circuits in which a switchable capacitor may be switched between being part of the input path or the feedback path of an amplifier, allowing the capacitance ratio to be changed accordingly. This scheme may provide for a significant reduction in the number of capacitors required to achieve a configurable gain ratio. Furthermore, embodiments of the present invention may provide for significant improvements in PSRR performance by providing a mechanism through which capacitors that are not needed can be tied to a predetermined level so as to not be left floating.

While specific embodiments of the present invention have been described in detail, it will be appreciated by those skilled in the art that the embodiments described in detail are not limiting on the scope of the claimed invention.

## Claims

1. An electronic device having a device input terminal and a device output terminal, the device comprising:
an amplifier having an amplifier input terminal and an amplifier output terminal, said amplifier output terminal being connected to the device output terminal;
an input capacitor having a first terminal thereof connected to the device input terminal, and a second terminal thereof connected to the amplifier input terminal;
a feedback capacitor having a first terminal thereof connected to the amplifier output terminal, and a second terminal thereof connected to the amplifier input terminal; and
a switchable capacitor having a first terminal thereof connected to the amplifier input terminal, and a second terminal thereof connected to a respective first terminal of each of a first switch, a second switch, and a third switch;
wherein the first switch has a second terminal thereof connected to the device input terminal;
wherein the second switch has a second terminal thereof connected to the amplifier output terminal; and
wherein the third switch has a second terminal thereof connected to ground or virtual ground, such that the switchable capacitor may be disconnected altogether when it is not required.

2. The electronic device as claimed in any preceding claim, further comprising:
a second switchable capacitor having a first terminal thereof connected to the amplifier input terminal, and a second terminal thereof connected to a respective first terminal of each of a fourth switch and a fifth switch;
wherein the fourth switch has a second terminal thereof connected to the device input terminal; and
wherein the fifth switch has a second terminal thereof connected to the amplifier output terminal.

3. The electronic device as claimed in claim 2, further comprising:
a third switchable capacitor having a first terminal thereof connected to the amplifier input terminal, and a second terminal thereof connected to the respective first terminals of the fourth and fifth switches.

4. The electronic device as claimed in claim 2 or 3, wherein the second terminal of the second switchable capacitor is connected to a first terminal of a sixth switch, wherein a second terminal of said sixth switch is connected to a second predetermined reference voltage.

5. The electronic device as claimed in claim 4, wherein the second predetermined reference voltage is ground or virtual ground.

6. The electronic device as claimed in any preceding claim, wherein each of the capacitors has a respective capacitance equal to a respective integer multiple of a unit capacitance.

7. The electronic device as claimed in any preceding claim, further comprising:
a first sampling switch having a first terminal thereof connected to the amplifier input terminal and a second terminal thereof connected to a third predetermined reference voltage;
a second sampling switch having a first terminal thereof connected to the amplifier output terminal and a second terminal thereof connected to a fourth predetermined reference voltage; and
a third sampling switch having a first terminal thereof connected to the device input terminal and a second terminal thereof connected to the first terminal of the input capacitor.

8. The electronic device as claimed in claim 7, wherein the first, second, and third sampling switches are controlled or controllable such that when said switches are disabled, the first sampling switch is disabled before the second and third sampling switches are disabled.

9. The electronic device as claimed in any preceding claim, further comprising:
a first amplifier enable switch having a first terminal thereof connected to the amplifier output terminal and a second terminal thereof connected to the second terminal of the feedback capacitor; and
a second amplifier enable switch having a first terminal thereof connected to the first terminal of the input capacitor.

10. The electronic device as claimed in claim 9, wherein a second terminal of the second amplifier enable switch is connected to a fifth predetermined reference voltage.

11. The electronic device as claimed in claim 10, wherein the fifth predetermined reference voltage is ground or virtual ground.

12. The electronic device as claimed in any preceding claim, wherein the electronic device has a second device input terminal and a second device output terminal, wherein:
the amplifier has a second amplifier input terminal and a second amplifier output terminal, said second amplifier output terminal being connected to the second device output terminal;
wherein the electronic device further comprises:
a second input capacitor having a first terminal thereof connected to the second device input terminal, and a second terminal thereof connected to the second amplifier input terminal;
a second feedback capacitor having a first terminal thereof connected to the second amplifier output terminal, and a second terminal thereof connected to the second amplifier input terminal; and
a fourth switchable capacitor having a first terminal thereof connected to the second amplifier input terminal, and a second terminal thereof connected to a respective first terminal of each of a seventh switch and an eighth switch;
wherein the seventh switch has a second terminal thereof connected to the second device input terminal; and
wherein the eighth switch has a second terminal thereof connected to the second amplifier output terminal.

13. The electronic device as claimed in claim 12, wherein:
the first amplifier input is an inverting input;
the second amplifier input is a non-inverting input;
the first amplifier output is a non-inverting output; and
the second amplifier output is an inverting output.

14. The electronic device as claimed in any preceding claim, wherein one or more of the capacitors respectively comprises a metal capacitor.
